# EUROPÄISCHE PATENTSCHRIFT

(11) **EP 1 731 914 B1**
(45) Veröffentlichungstag und Bekanntmachung des Hinweises auf die Patenterteilung: **24.08.2011**
(21) Anmeldenummer: 05012519.4
(22) Anmeldetag: 10.06.2005
(51) Int. Cl.: G01R 11/04, H05K 5/02

(54) **Funktionseinheit für ein elektrisches oder elektronisches Gerät**
Functional unit for an electric or an electronic apparatus
Unité fonctionnelle pour un appareil électrique ou électronique

(43) Veröffentlichungstag der Anmeldung: 13.12.2006
(73) Patentinhaber: Landis+Gyr AG, 6300 Zug (CH)
(72) Erfinder: Janssen, Peter, 6313 Menzingen (CH)
(74) Vertreter: Lagler, Louis

(56) Entgegenhaltungen:
- EP-A- 0 598 520
- CH-A5- 690 949
- GB-A- 2 295 682
- GB-A- 2 300 724

## Beschreibung

Die Erfindung fällt in das Gebiet der elektrischen und/oder elektronischen Geräte; sie betrifft ein solches Gerät mit einer Funktionseinheit.

Stand der Technik

Herkömmliche Geräte weisen beispielsweise ausserhalb eines gesicherten Geräteteils einen um eine Drehachse aufklappbaren Gerätedeckel auf. An einer Innenwand des aufklappbaren Gerätedeckels ist eine Funktionseinheit zur Unterbringung einer Batterie in der Nähe einer Drehachse des Gerätedecks lösbar befestigt. Bei offenem Gerätedeckel ist die Einrichtung zur Unterbringung der Batterie so zugänglich, dass sie schnell austauschbar ist. Batterie-Anschlussverbindungen sind aus der Einrichtung heraus- und zum gesicherten Gerätetell so geführt, dass sie zusammen mit der Einrichtung schnell austauschbar sind. Mit der Anordnung ist ein einfacher und schneller Batterieaustausch ohne ein Abmontieren des Gerätes, ohne einen Unterbruch der Netzspannungszufuhr und ohne Beschädigung einer Eichplombe für ein elektrisches/elektronisches Gerät möglich. Die CH 690 949 beschreibt ein solches Gerät nach dem Stand der Technik.

Obwohl dieses bekannte Gerät allen Sicherheitsstandards entspricht, wäre bei nicht sachgerecht ausgeführtem Austausch eine Berührung der Batterie-Anschlussverbindung zumindest mittels eines Werkzeugs möglich. Darüber hinaus wäre sogar eine bewusst, betrügerische Manipulation des Gerätes an der Stelle möglich, an der sich die Funktionseinheit im Betriebszustand normalerweise befindet.
Ferner zeigen die EP 598 520 A2, die GB 2 300 724 A und die GB 2 295 682 A jeweils eine Funktionseinheit für ein elektrisches und/oder elektronisches Gerät, insbesondere für einen Elektrizltätszähler, wobei die Funktionseinheit in einem Betriebszustand des Gerätes unlösbar an diesem angeordnet ist und aus einer Betriebsposition in eine Serviceposition und zurück bedienbar ist zwecks Handhabung einer an der Funktionseinheit angeordneten Anzahl von Baueinheiten, welche Anzahl Baueinheiten in der Betriebsposition der Funktionseinheit im Gerät eine Wirkverbindung aufweisen und wobei die Baueinheiten in der Serviceposition der Funktionseineinheit frei sind von einer Wirkverbindung. Diesen bekannten Geräten ist gemeinsam, dass die Funktionseinheiten von den Geräten trennbar sind und somit an den Geräten und/oder den Funktionseinheiten angeordnete Kontakte für die Wirkverbindung in der Serviceposition berührbar sind. Somit kann von diesen Kontakten wegen einer möglichen Spannungsberührung eine entsprechende Gefährdung ausgehen und/oder an ihnen eine unberechtigte Manipulation des Geräts und/oder der Funktionseinheit vorgenommen werden.

Darstellung der Erfindung

Der Erfindung liegt die Aufgabe zugrunde, bekannte Vorrichtungen so weiter zu bilden, dass die aufgezeigten Probleme überwunden werden und somit ein Gerät mit einer Funktionseinheit angegeben wird, wobei jederzeit, das heisst im Betriebsfall und im Servicefall, ausreichende Sicherheit gegenüber einer unbewussten oder bewussten Spannungsberührung innerhalb eines elektrischen und/oder elektronischen Geräts bietet.

Die Lösung der der Erfindung zugrunde liegenden Aufgabe ist im Anspruch 1 angegeben. Den Erfindungsgedanken vorteilhaft weiterbildende Merkmale sind Gegenstand der Unteransprüche 2 bis 7,

Der Kern der vorliegenden Erfindung ist darin zu sehen, dass die Funktionseinheit eine Anzahl Führungsnocken aufweist, die ein grösseres Profilmass aufweisen als eine Öffnung in einem Gehäuseteil des Geräts, durch die die Funktionseinheit bedienbar ist, so dass die Funktionseinheit auch in der Serviceposition unlösbar an dem Gerät angeordnet ist.

Mit Vorteil verdeckt die Funktionseinheit nach der Erfindung sowohl in der Betriebsposition, als auch in der Serviceposition die Wirkverbindungen vollständig, so dass weder eine unbewusste, noch eine bewusste Berührung spannungsführender Teile in dem Gerät möglich ist. Somit ist das Gefahrenpotential bei der Handhabung von Baueinheiten in der Funktionseinheit beseitigt.

Eine vorteilhafte Ausgestaltung der Erfindung sieht vor, dass die Anzahl Führungsnocken in entsprechende Nutelemente innerhalb des Gerätes eingreifen zwecks schubladenartiger Bedienung der Funktionseinheit. Diese Führungsnocken sind innerhalb des Geräts angeordnet, wobei das Gerät selbst gegen unbefugten Zugriff mit einer Eichplombierung versehen ist.

Somit ist die Funktionseinheit dem Gerät nicht entnehmbar, wohl aber die an ihr angeordneten Baueinheiten in ausgezogener Serviceposition der schubladenartigen Funktionseinheit.

Funktionseinheit ist mit einer serviceplombierten Abdeckung gesichert und nur für entsprechend geschultes und berechtigtes Personal zugänglich.

Kurze Beschreibung der Figuren

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen die

Fig. 1: eine Ansicht eines elektrischen bzw. elektronischen Geräts anhand eines Elektrizitätszählers;

Fig. 2: das Gerät mit einer erfindungsgemässen Funktionseinheit in einer Betriebspostion;

Fig. 3: die Funktionseinheit in einer Serviceposition;

Fig. 4: eine weitere Ansicht der Funktionseinheit in Serviceposition;

Fig. 5: die Funktionseinheit mit einer Anzahl Baueinheiten,

Fig. 6: eine Innenansicht des Geräts und

Fig. 7: ein Schnittdarstellung des Geräts.

Wege zur Ausführung der Erfindung, gewerbliche Verwendbarkeit

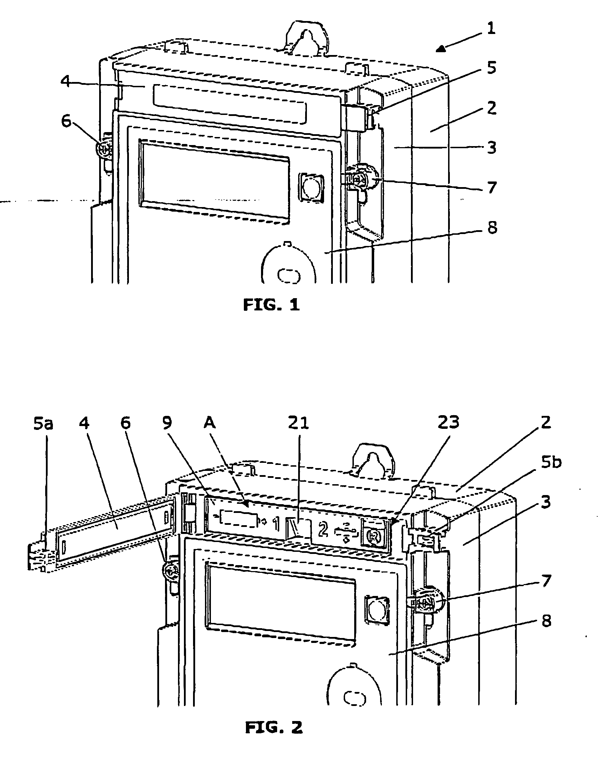

Fig. 1 zeigt ein elektrisches bzw. elektronisches Gerät 1 am Beispiel eines Elektrizitätszählers. Dieses Gerät 1 umfasst einen Gehäuseunterteil 2, der mit einem Gehäuseoberteil 3 verschlossen ist. Auf einer Frontseite ist das Gerät 1 mit einer ersten Abdeckung 4 und einer zweiten Abdeckung 8 versehen. Des Weiteren ist eine Eichplomblerung 6 vorgesehen, mit der das Innere des Geräts 1 vor unbefugtem Zugriff geschützt wird. Eine weitere Plombierung 7 sichert die Abdeckung 8 am Gehäuseoberteil 3. Diese weitere Plombierung 7 kann zu Servicezwecken geöffnet werden, ohne dass das Gerät 1 seine Eichgültigkeit (Plombierung 6) verliert. Eine dritte Plombierung 5 sichert die erste Abdeckung 4 gegen Öffnen; hier handelt es sich auch um eine Plombierung, die zu Servicezwecken -entweder im Bedarfsfall oder periodisch- geöffnet wird. Diese dritte Plombierung 5 ist im Gegensatz zu den Plombierungen 6 und 7 ohne einen Plombe gezeigt. Lediglich die Plombierungen 6 und 7 weisen in der figürlichen Darstellung einen Plombierstift als Plombe auf.

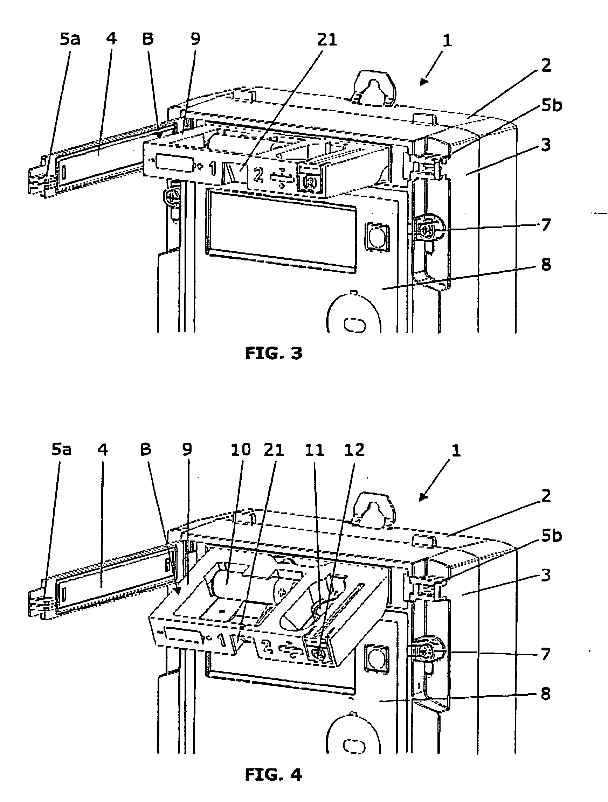

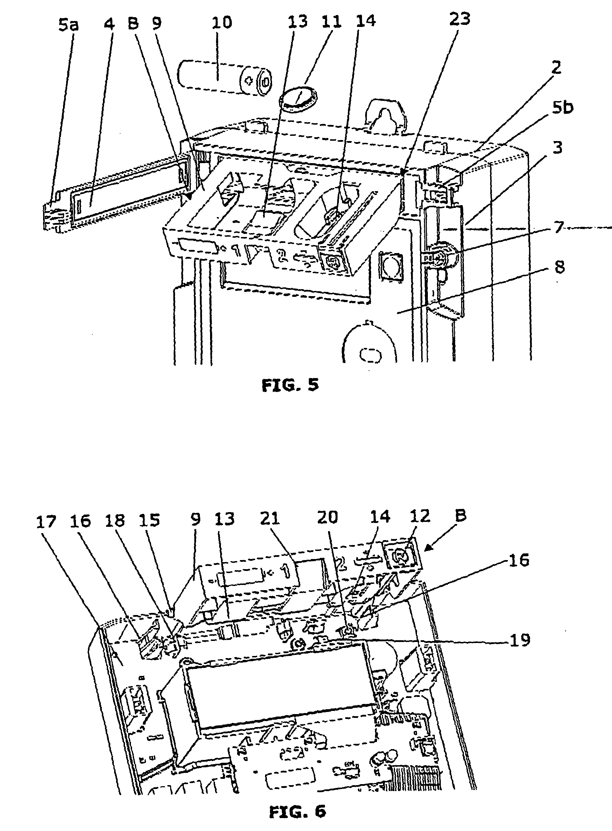

Fig. 2 zeigt die Abdeckung 4 in einer geöffneten Position, wobei sichtbar ist, wie die Plombierung 5 aus zueinander komplementären Teilen 5a und 5b zusammensetzt ist. Die geöffnete Abdeckung 4 gibt die Sicht auf eine erfindungsgemässe Funktionseinheit 9 frei, die sich in einer Betriebsposition A befindet. Durch Herausziehen dieser Funktionseinheit 9 an einer Griffmulde 21 kann, wie die Fig. 3 erhellt, die Funktionseinheit 9 aus einer Öffnung 23 des Gehäuseoberteils 3 in eine Serviceposition B geführt werden. An dieser Stelle sei zunächst lediglich darauf hingewiesen, dass im Weiteren zu Fig. 6 zu erläutern sein wird, dass diese Funktionseinheit 9 nicht weiter aus dem Gerät 1 ausfahrbar ist, als die Serviceposition B erlaubt.

Fig. 4 offenbart nun, dass die ausgefahrene Funktionseinheit 9 leicht nach unten abschwenkbar ist und eine Anzahl von Baueinheit (10, 11, 12) an ihr angeordnet ist. Diese Baueinheiten umfassen im Beispielsfall eine erste Batterie 10, eine zweite Batterie 11 und eine Taste 12. Selbstverständlich ist ebenfalls im Sinne der Erfindung denkbar, jede beliebige Baueinheit in der Funktionseinheit 9 unterzubringen; ergänzend -aber keinesfalls abschliessend- sei hier nur noch ein Schaltknopf oder ein Funktionsmodul erwähnt, wobei unter Funktionsmodul jede elektrische Moduleinheit verstanden wird, die mit dem Gerät 1 In Wirkverbindung treten soll.

Die Fig. 5 zeigt die Funktionseinheit 9 mit den Batterien 10 und 11 in einer explosionsartigen Darstellung. Hierdurch wird deutlich, dass die Batterien 10 und 11 mittels jeweils einem Rastelement 13 bzw. 14 in der Funktionseinheit 9 gehalten sind. Hierzu wird auch auf Fig. 6 verwiesen, in welcher die Rastelemente 13 und 14 in einer Ansicht von unten auf die Funktionseinheit 9 gezeigt sind.

Die Funktionseinheit 9 ist in der Fig. 6 in der Serviceposition B dargestellt. Jeweils seitlich an der Funktionseinheit 9 sind Führungsnocken 15 angeordnet, die in entsprechen Führungsschienen 16 gelagert sind, wenn die Funktionseinheit 9 in die Betriebsposition A (siehe Fig. 2) überführt wird. Da das Profilmass der Führungsnocken 15 grösser ist, als die Öffnung 23 in dem Gehäuseoberteil 3 für die Funktionseinheit 9, kann die Funktionseinheit 9 nicht aus dem Gerät 1 entfernt werden, wenn das Gehäuseoberteil 3 montiert und plombiert ist, siehe auch Fig. 2.

Bei gemeinsamer Betrachtung der Fig. 5 und 6 wird deutlich, dass die Batterie 10 mit einer Platine 17 über ein Kontaktpaar 18 in Wirkverbindung tritt und die Batterie 10 über ein Kontaktpaar 19 eine weitere Wirkverbindung mit der Platine 17 aufweist. Des Weiteren ist die Taste 12 mit dem Taster 20 auf der Platine 17 verbunden, wenn die Funktionseinheit 9 aus der Serviceposition B in die Betriebsposition A gefahren wird.

Gemäss der vorliegenden Erfindung ist bei geschlossenem Gerät 1 die Öffnung 23 vollständig verschlossen durch die Funktionseinheit, und das sowohl wenn die Funktionseinheit in der Betriebsposition A ist, als auch wenn sie sich in der Serviceposition B befindet. Somit ist erstmalig jede in der Funktionseinheit 9 integrierte Baueinheit (10, 11, 12) auswechselbar, ohne dass ein Zugriff auf in dem Gerät 1 installierte Einheiten, wie eine Platine, zugänglich wären. Darüber hinaus können die Baueinheiten (10, 11, 12) völlig spannungsberührungssicher aus der Funktionseinheit 9 entnommen, bzw. in diese eingesetzt werden, da jede Wirkverbindung, die eine Baueinheit im Gerät 1 aufweist, beim Herausfahren von der Betriebsposition A zur Serviceposition B getrennt wird.

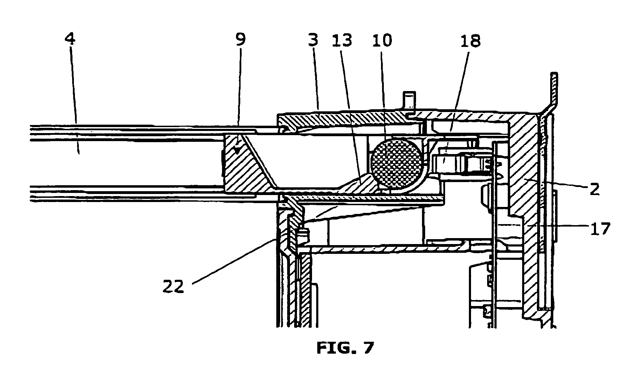

Dies verdeutlicht auch Fig. 7, die eine Schnittdarstellung durch das Gehäuse zeigt. Die Funktionseinheit 9 befindet sich In einer Position zwischen der Betriebsposition A und der Serviceposition B bei geöffneter Abdeckung 4. Bereits in dieser Zwischenposition ist die Batterie -die hier beisplelhaft für die weitere, hier nicht gezeigte Batterie 11 und die Taste 12 steht- bereits aus der Wirkverbindung mit der Platine 17 herausgeführt, so dass die Kontakte 18 sichtbar sind. Das Rastelement 13 für die Batterie 10 in der Funktionseinheit 9 ist mittels der Verriegelung 22 gegen unbeabsichtigtes Lösen gesichert. Die Batterie 10 kann somit ihre Lage gegenüber der Funktionseinheit 9 nicht verändern, sobald letztere in die besagte Zwischenposition überführt wird.

Erfindungsgemäss ist jedes elektrische bzw. elektronische Gerät denkbar, bei dem ein oben beschriebene Funktionseinheit zur Anwendung gelangen kann. Keinesfalls wird die Erfindung durch die obige Beschreibung anhand des Ausführungsbeispiels für einen Elektrizitätszähler auf einen solchen Elektrlzltätszähler eingeschränkt.

### Bezugszeichenliste

- 1: Gehäuse für ein elektronisches Gerät
- 2: Gehäuseunterteil
- 3: Gehäuseoberteil
- 4: Abdeckung von 9
- 5, 5a, 5b: Plombierung
- 6: Plombierung
- 7: Plombierung
- 8: Abdeckung
- 9: Funktionseinheit
- 10: Batterie
- 11: Batterie
- 12: Taste bzw. Schaltknopf
- 13: Rastelement
- 14: Rastelement
- 15: Führungselement
- 16: Führungsschiene
- 17: Platine
- 18: Kontaktfeder
- 19: Kontaktfeder
- 20: Taster
- 21: Griffmulde
- 22: Verriegelung
- 23: Öffnung im Gerät 1
- A: Betriebsposition
- B: Serviceposition

## Patentansprüche

1. Elektrisches und/oder elektronisches Gerät (1), Insbesondere ein Elektrizitätszähler mit einer Funktionseinheit (9), wobei die Funktionseinheit (9) in einem Betriebszustand des Gerätes (1) unlösbar an diesem angeordnet Ist und aus einer Betriebsposition (A) in eine Serviceposition (B) und zurück bedienbar ist zwecks Handhabung einer an der Funktionseinheit (9) angeordneten Anzahl von Baueinheiten (10, 11, 12), welche Anzahl Baueinheiten (10, 11, 12) in der Betriebsposition (A) der Funktionseinheit (9) im Gerät (1) eine Wirkverbindung (18, 19) aufweisen und wobei die Baueinheiten (10, 11, 12) in der Serviceposition (B) der Funktionseineinheit (9) frei sind von der wirkverbindung (18, 19) **dadurch gekennzeichnet,**
**dass** die Funktionseinheit schubladenartig in dem elektrischen/elektronischen Gerät angeordnet Ist, und
**dass** die Funktionselnheit (9) eine Anzahl Führungsnocken (15) aufweist, die in entsprechende Nutelemente (16) innerhalb des Geräts (1) eingreifen, und welche Führungsnocken (15) ein grösseres Profilmass aufweisen als eine Öffnung (23) In einem Gehäuseteil (3) des Geräts (1), durch die die Funktionseinheit (9) bedienbar ist, so dass die Funktionseinheit (9) auch in der Serviceposition (B) unlösbar an dem Gerät (1) angeordnet ist.

2. Elektrisches und/oder elektronisches Gerät (1) nach Anspruch 1, **dadurch gekennzeichnet, dass** die Funktionseinheit (9) sowohl in der Betriebsposition (A), als auch in der Serviceposition (B) die Wirkverbindungen (18, 19) unzugänglich verdeckt.

3. Elektrisches und/oder elektronisches Gerät (1) nach Anspruch 1 oder 2, **dadurch gekennzeichnet, dass** die Anzahl Baueinheiten (10, 11, 12) mindestens eine Batterie und/oder eine Anzeige und/oder ein Funktionsmodul und/oder eine Taste und/oder einen Schaltknopf umfasst.

4. Elektrisches und/oder elektronisches Gerät (1) nach einem der vorhergehenden Ansprüche, **dadurch gekennzeichnet, dass** die Baueinheit (10, 11) mittels mindestens eines Rastelements (13, 14) in der Funktionseinheit (9) fixierbar angeordnet ist.

5. Elektrisches und/oder elektronisches Gerät (1) nach Anspruch 4, **dadurch gekennzeichnet, dass** das mindestens eine Rastelement (13, 14) mittels mindestens einer Verriegelung (22) beim Übergang von der Serviceposition (B) zur Betriebsposition (A) verriegelbar angeordnet ist.

6. Elektrisches und/oder elektronisches Gerät (1) nach einem der vorstehenden Ansprüche, **dadurch gekennzeichnet, dass** die Funktionseinheit (9) mittels einer Serviceplombierung (5) gesichert ist.

7. Elektrisches und/oder elektronisches Gerät (1) nach einem der vorstehenden Ansprüche, **dadurch gekennzeichnet, dass** die Funktionseinheit (9) mit einer eine Serviceplombierung (5) aufweisenden Abdeckung (4) gesichert ist.

## Claims

1. Electrical and/or electronic device (1), in particular an electricity meter, having a functional unit (9), with the functional unit (9) being arranged on the device (1) in a non-detachable manner in an operating state of the said device and it being possible to move the said functional unit from an operating position (A) to a service position (B), and back, for the purpose of operating a number of units (10, 11, 12) which are arranged on the functional unit (9) and which number of units (10, 11, 12) have an operative connection (18, 19) in the operating position (A) of the functional unit (9) in the device (1), and with the units (10, 11, 12) being free of the operative connection (18, 19) in the service position (B) of the functional unit (9),
**characterized**
**in that** the functional unit is arranged in the manner of a drawer in the electrical/electronic device, and
**in that** the functional unit (9) has a number of guide cams (15) which engage in corresponding groove elements (16) within the device (1), and which guide cams (15) have larger profile dimensions than an opening (23) in a housing part (3) of the device (1) through which opening the functional unit (9) can be moved, and therefore the functional unit (9) is arranged on the device (1) in a non-detachable manner in the service position (B) too.

2. Electrical and/or electronic device (1) according to Claim 1, **characterized in that** the functional unit (9) conceals the operative connections (18, 19) such that they are inaccessible both in the operating position (A) and in the service position (B).

3. Electrical and/or electronic device (1) according to Claim 1 or 2, **characterized in that** the number of units (10, 11, 12) comprises at least a battery and/or a display and/or a functional module and/or a key and/or a control button.

4. Electrical and/or electronic device (1) according to one of the preceding claims, **characterized in that** the unit (10, 11) is arranged such that it can be fixed in the functional unit (9) by means of at least one latching element (13, 14).

5. Electrical and/or electronic device (1) according to Claim 4, **characterized in that** the at least one latching element (13, 14) is arranged such that it can be locked by means of at least one locking means (22) as it moves from the service position (B) to the operating position (A).

6. Electrical and/or electronic device (1) according to one of the preceding claims, **characterized in that** the functional unit (9) is secured by means of a service seal (5).

7. Electrical and/or electronic device (1) according to one of the preceding claims, **characterized in that** the functional unit (9) is secured by a cover (4) which has a service seal (5).

## Revendications

1. Appareil électrique et/ou électronique (1), notamment compteur d'électricité, doté d'une unité fonctionnelle (9), l'unité fonctionnelle (9) étant disposée, dans un état de fonctionnement de l'appareil (1), de façon inamovible au niveau de celui-ci et pouvant être déplacée d'une position de fonctionnement (A) dans une position d'entretien (B) puis être ramenée dans la première position à des fins de manipulation d'un certain nombre d'unités de construction (10, 11, 12) disposées au niveau de l'unité fonctionnelle (9), ledit nombre d'unités de construction (10, 11, 12) comportant, dans la position de fonctionnement (A) de l'unité fonctionnelle (9) placée dans l'appareil (1), une liaison active (18, 19) et les unités de construction (10, 11, 12) étant sorties de l'emprise, dans la position d'entretien (B) de l'unité fonctionnelle (9), de la liaison active (18, 19), **caractérisé en ce que** :
l'unité fonctionnelle est disposée à la façon d'un tiroir dans l'appareil électrique/électronique ; et
l'unité fonctionnelle (9) comporte un certain nombre de cames de guidage (15) s'engrenant dans les éléments de rainure (16) correspondants à l'intérieur de l'appareil (1) et lesdites cames de guidage (15) comportant une dimension de profil plus importante que celle d'une ouverture (23) pratiquée dans une partie de boîtier (3) de l'appareil (1) à travers laquelle l'unité fonctionnelle (9) peut être manipulée, de sorte que l'unité fonctionnelle (9) est disposée de façon inamovible au niveau de l'appareil (1), et ce également dans la position d'entretien (B).

2. Appareil électrique et/ou électronique (1) selon la revendication 1, **caractérisé en ce que** l'unité fonctionnelle (9) recouvre les liaisons actives (18, 19) tant dans la position de fonctionnement (A) que dans la position d'entretien (B) de façon à les rendre inaccessibles.

3. Appareil électrique et/ou électronique (1) selon la revendication 1 ou 2, **caractérisé en ce que** le nombre d'unités de construction (10, 11, 12) comprend au moins une batterie et/ou un affichage et/ou un module fonctionnel et/ou une touche et/ou un bouton de commutation.

4. Appareil électrique et/ou électronique (1) selon l'une quelconque des revendications précédentes, **caractérisé en ce que** l'unité de construction (10, 11) est disposée de façon à pouvoir être fixée dans l'unité fonctionnelle (9) à l'aide d'au moins un élément d'encliquetage (13, 14).

5. Appareil électrique et/ou électronique (1) selon la revendication 4, **caractérisé en ce que** l'au moins un élément d'encliquetage (13, 14) est disposé de façon verrouillable à l'aide d'au moins un verrouillage (22) lors du passage de la position d'entretien (B) à la position de fonctionnement (A).

6. Appareil électrique et/ou électronique (1) selon l'une quelconque des revendications précédentes, **caractérisé en ce que** l'unité fonctionnelle (9) est protégée à l'aide d'un plombage de maintenance (5).

7. Appareil électrique et/ou électronique (1) selon l'une quelconque des revendications précédentes, **caractérisé en ce que** l'unité fonctionnelle (9) est protégée à l'aide d'un cache (4) comportant un plombage de maintenance (5).
